# EUROPEAN PATENT APPLICATION

(11) **EP 4 629 283 A1**
(43) Date of publication of application: **08.10.2025**
(21) Application number: 23896892.9
(22) Date of filing: 30.11.2023
(51) Int. Cl.: H01L 21/677

(54) **SUBSTRATE TREATMENT APPARATUS**

(30) Priority: 01.12.2022 CN 202211536503
(71) Applicant: ACM Research (Shanghai) Inc., Shanghai 201203 (CN)
(72) Inventor: WANG, Hui, Shanghai 201203 (CN); JIA, Shena, Shanghai 201203 (CN); DENG, Xinping, Shanghai 201203 (CN)
(74) Representative: Osha BWB
(86) International application number: PCT/CN2023/135544
(87) International publication number: WO 2024/114750

(57) **Abstract**

The present invention provides a substrate treatment apparatus. The substrate treatment apparatus is connected in series with a plurality of vertically moving process manipulators by a horizontally moving transfer manipulator, so as to realize the transmission of the substrate from the front end to the back end of the apparatus, or the transmission of the substrate from the back end to the front end of the apparatus. The transfer manipulator transmits a plurality of substrates at one time, which can ensure that a plurality of substrates to be processed or processed substrates handled by the process manipulators can be transferred in time. The process manipulators move in the vertical direction to be responsible for the transmission tasks of a plurality of treatment chambers. The moving stroke of each process manipulator is shortened and the load is uniform, which is beneficial to reducing the time interval of substrate transmission, improving the transmission efficiency of the substrate, reducing the idle time of the treatment chambers, and further improving the overall production capacity of the apparatus.

## Description

### FIELD OF THE INVENTION

The present invention relates to the field of semiconductor manufacturing equipment, and more particularly to a substrate treatment apparatus.

### BACKGROUND

Semiconductor cleaning apparatus includes single cleaning apparatus and batch cleaning apparatus. Wherein, the single cleaning apparatus has excellent cleaning effect, but the treatment capacity of the single cleaning apparatus is insufficient compared with the batch cleaning apparatus.

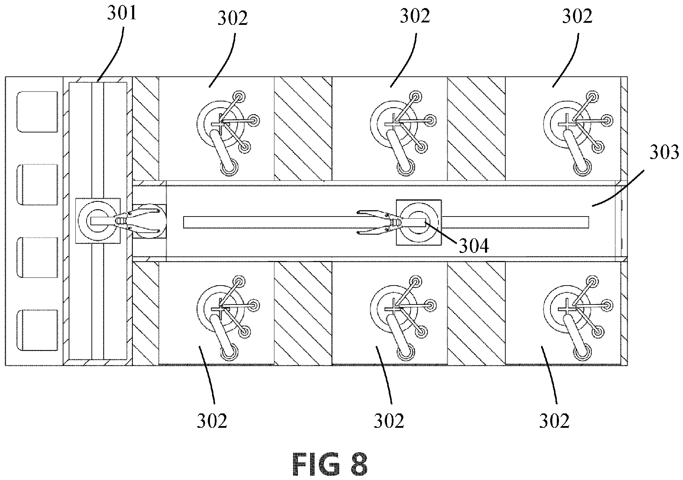

FIG. 8 is a plan layout of a general single cleaning apparatus. The single cleaning apparatus comprises a front-end module 301, a plurality of cleaning chambers 302 and a transmission channel 303. The plurality of cleaning chambers 302 are arranged along the longitudinal direction of the transmission channel 303, and are disposed at both sides of the transmission channel 303. A master manipulator 304 is arranged in the transmission channel 303, and the master manipulator 304 is used to get wafers from the front-end module 301 and distribute the wafers to the plurality of cleaning chambers 302, or to get cleaned wafers from the plurality of cleaning chambers 302 and transfer the cleaned wafers back to the front-end module 301.

In order to increase the production capacity of the single cleaning apparatus, one of the necessary means is to increase the number of cleaning chambers 302. As the number of cleaning chambers 302 increases, the distance of the transmission channel 303 is also extended, which will reduce the transfer efficiency of the master manipulator 304, and then affect the improvement of the production capacity of the whole apparatus. And the effect will be greater and greater as the number of cleaning chambers 302 increases.

### SUMMARY

In view of the above-described shortcomings of the prior art, an object of the present invention is to provide a substrate treatment apparatus, for solving the problems of insufficient transmission efficiency of a substrate treatment apparatus and suppressing the production capacity of the apparatus in the prior art.

In order to achieve the above object and other related objects, the present invention provides a substrate treatment apparatus, comprising a front-end module and a treatment module connected in sequence,
the front-end module being configured with loading platform and a front-end manipulator, a carrier being provided on the loading platform, the carrier being used for storing the substrate, and the front-end manipulator being used for taking and placing the substrate in the carrier;
the treatment module comprising:
   a plurality of treatment units, the plurality of treatment units being the first treatment unit to the Nth treatment unit arranged in sequence from the front end to the back end of the treatment module, an i-th process manipulator, an i-th lifting buffer box, and a plurality of treatment chambers arranged in a stack being configured for the i-th treatment unit, the first treatment unit being arranged adjacent to the front-end module, and the first treatment unit being further configured with a fixed buffer box, wherein, N is a positive integer and N ≥ 2, and i is a positive integer and 1 ≤ i ≤ N; and
   a transfer manipulator, configured for moving between the first treatment unit to the Nth treatment unit;
   wherein, the front-end manipulator is configured for transmitting the substrate between the carrier and the fixed buffer box; a first process manipulator transmits the substrate between the fixed buffer box and a plurality of treatment chambers of the first treatment unit;
   the front-end manipulator is further used to transmit the substrate between the carrier and the first lifting buffer box; the transfer manipulator transmits the substrate between the first lifting buffer box and the j-th lifting buffer box, and the j-th process manipulator is used to transmit the substrate between the j-th lifting buffer box and a plurality of treatment chambers of the j-th treatment unit, j is a positive integer and 2 ≤ j ≤ N.

As an option of the present invention, the treatment module further comprises a transverse guiding rail, and the transfer manipulator is mounted on the transverse guiding rail, so that the transfer manipulator moves between the first treatment unit to the Nth treatment unit.

As an option of the present invention, the treatment module further comprises a first vertical guiding rail, the i-th process manipulator is disposed on the first vertical guiding rail, and the i-th process manipulator is lifted and lowered along the first vertical guiding rail, so as to approach the treatment chamber of any height.

As an option of the present invention, the treatment module further comprises a second vertical guiding rail, the i-th lifting buffer box is disposed on the second vertical guiding rail, and the i-th lifting buffer box is lifted and lowered along the second vertical guiding rail, so as to move between the position approaching the transfer manipulator and the position avoiding the transfer manipulator.

As an option of the present invention, a plurality of treatment chambers in each treatment unit are stacked in a row in the vertical direction and provided on one side of the moving path of the transfer manipulator, or stacked in two rows distributed on both sides of the moving path of the transfer manipulator and provided opposite to each other.

As an option of the present invention, the front-end manipulator and the transfer manipulator are respectively configured with M piece-taking arms and M piece-placing arms, wherein, M and P are positive integers, and M ≤ P, and P is the number of treatment chambers configured for each treatment unit.

As an option of the present invention, in the front-end manipulator, M piece-taking arms have at least one piece-taking arm that independently takes up the piece; M piece-placing arms have at least one piece-placing arm that independently places the piece.

As an option of the present invention, each treatment unit is configured with two lifting buffer boxes moving independently, wherein, one of the two lifting buffer boxes is configured for placing the substrate to be processed, and the other of the two lifting buffer boxes is configured for placing the processed substrate.

As mentioned above, the present invention provides a substrate treatment apparatus, in a method of a horizontally moving transfer manipulator is connected in series with a plurality of vertically moving process manipulators, realizing a transmission of the substrate from the front end to the back end of the apparatus, or a transmission of the substrate from the back end to the front end of the apparatus. The transfer manipulator transmits a plurality of substrates at one time, which can ensure that a plurality of substrates to be processed or processed substrates handled by the process manipulators can be transferred in time. The process manipulators move in the vertical direction to be responsible for the transmission tasks of a plurality of treatment chambers. The moving stroke of each process manipulator is shortened and the load is uniform, which is beneficial to reducing the time interval of substrate transmission, improving the transmission efficiency of the substrate, reducing the idle time of the treatment chambers, and further improving the overall production capacity of the apparatus.

### BRIEF DESCRIPTION OF THE DRAWINGS

FIG. 1 is a perspective view of a substrate treatment apparatus according to embodiment 1 of the present invention;
FIG. 2 is a top view of a substrate treatment apparatus according to embodiment 1 of the present invention;
FIG. 3 is a side view of a substrate treatment apparatus according to embodiment 1 of the present invention;
FIG. 4 is a partial perspective view of a substrate treatment apparatus according to embodiment 1 of the present invention;
FIG. 5 is a flowchart of transmitting the substrate by a substrate treatment apparatus according to embodiment 1 of the present invention;
FIG. 6 is a top view of a substrate treatment apparatus according to embodiment 2 of the present invention;
FIG. 7 is a partial perspective view of a substrate treatment apparatus according to embodiment 2 of the present invention; and
FIG. 8 is a top view of a substrate treatment apparatus in the prior art.

### PREFERRED EMBODIMENTS OF THE INVENTION

Hereinafter, embodiments of the present invention will be described with specific and concrete embodiments, and other advantages and effects of the present invention will be readily apparent to those skilled in the art from the disclosure of this specification. The present invention can also be embodied or applied by other different and specific embodiments, and various details in this specification can also be modified or changed based on different viewpoints and applications without departing from the spirit of the present invention.

It should be noted that the drawings provided in the present embodiment illustrate the basic concept of the present invention only in a schematic manner. Although the components related to the present invention are shown in the drawings and are not drawn according to the numbers, shapes and sizes of the components in actual implementation, the form, number and proportion of each component in actual implementation may be arbitrarily changed, and the layout of the components may be more complicated.

### First embodiment

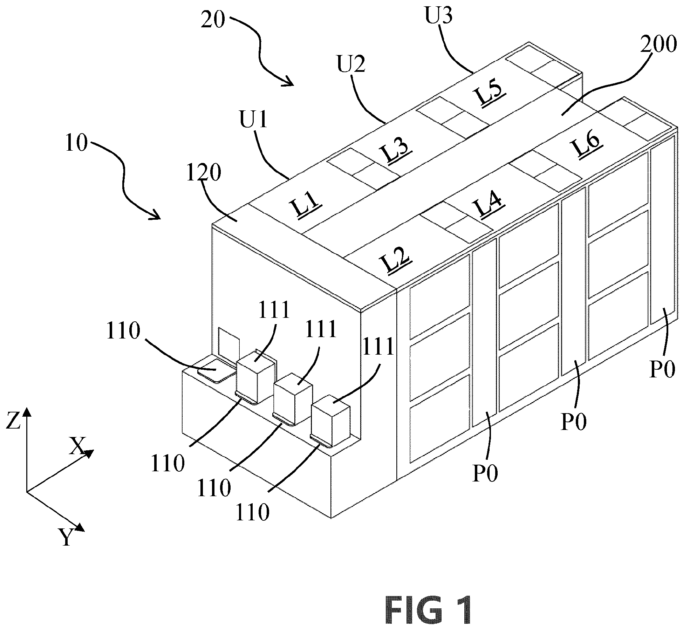

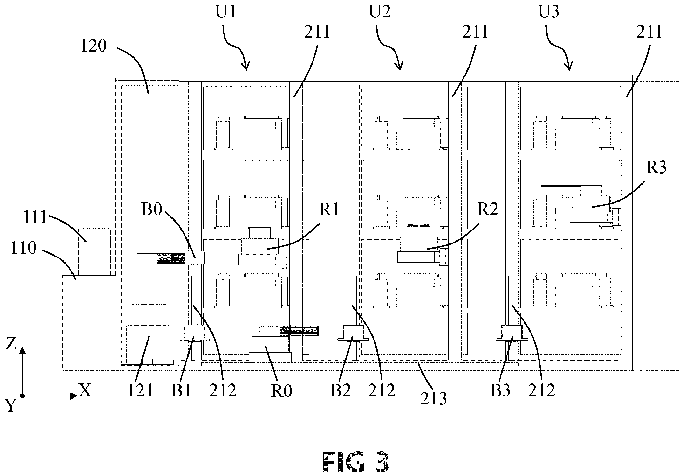

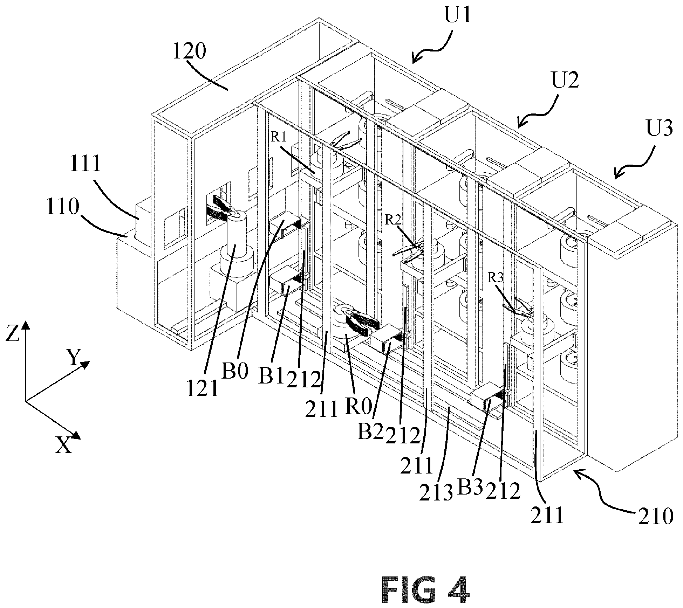

Please referring to FIGS. 1 to 4, the present embodiment provides a substrate treatment apparatus. The substrate treatment apparatus is used for treating the substrate, such as cleaning, etching, coating and developing. In the present embodiment, a wafer for semiconductor treatment will be described as an example of the substrate. In addition, the type of the substrate may be a substrate for an optical disk, a substrate for a photomask, a substrate for a solar cell, or the like.

Referring to FIG. 1, the substrate treatment apparatus comprises a front-end module 10 and a treatment module 20 connected in sequence. The arrangement direction of the front-end module 10 and the treatment module 20 is defined as the X direction, and the X direction is the front-back direction of the substrate treatment apparatus. The direction perpendicular to the X direction when viewed from the upper side is defined as the Y direction. The direction perpendicular to the plane where the X direction and the Y direction are located is defined as the Z direction.

Referring to FIG. 1, the front-end module 10 comprises loading platform 110 and a transfer chamber 120. The loading platform 110 are provided on the front side of the transfer chamber 120, and the carriers 111 for storing the substrate are provided on the loading platform 110. The carriers 111 are, for example, front-opening wafer transfer boxes (FOUP). The number of loading platform 110 can be set according to the floor area of the machine and the operation efficiency. In FIG. 1, the front-end module 10 is configured with four loading platform 110, and the four loading platform 110 are arranged in a line in the Y direction.

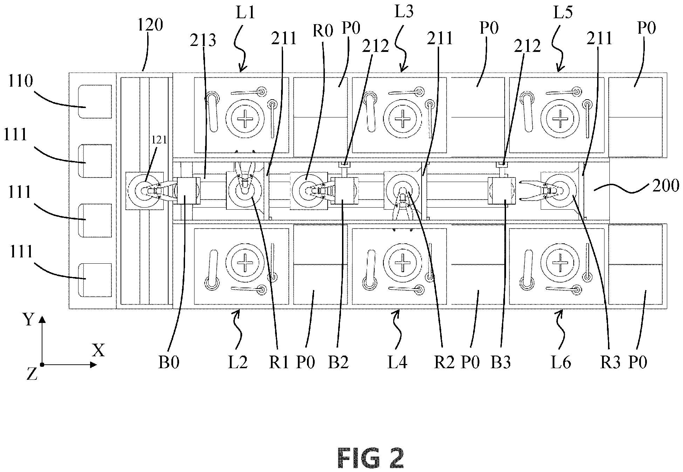

Referring to FIG. 2, a front-end manipulator 121 is configured for the transfer chamber 120 and is used for taking the substrate from the carriers 111, or placing the substrate in the carriers 111.

Referring to FIG. 1 again, the treatment module 20 is disposed on the back side of the transfer chamber 120. The central region of the treatment module 20 is configured as the transmission region 200. The treatment module 20 comprises a first treatment unit U1, a second treatment unit U2 and a third treatment unit U3 arranged in sequence from the front end to the back end (i.e., in the X direction) of the treatment module 20. The first treatment unit U1 is arranged adjacent to the transfer chamber 120. The treatment module 20 further comprises supply systems P0, and the supply systems P0 are arranged on the side surfaces of each of the treatment units U1 to U3, so that the overall layout of the apparatus can be more compact. The supply systems P0 are used to supply gas, liquid, and the like to each treatment chamber. It will be appreciated that in other embodiments, the supply systems P0 may also be configured below the treatment module 20.

Referring to FIGS. 1 to 4, the first treatment unit U1 is configured with a first process manipulator R1, a fixed buffer box B0, a first lifting buffer box B1 and two columns of treatment chambers L1 and L2. The treatment chambers L1 and L2 are disposed on both sides of the transmission region 200 oppositely. And each column of treatment chambers has three treatment chambers stacked in the vertical direction (i.e., the Z direction). Wherein, the first process manipulator R1 is responsible for transmitting the substrate between the fixed buffer box B0 and the two columns of treatment chambers L1 and L2 (that is, a plurality of treatment chambers of the first treatment unit U1, specifically, six treatment chambers). The second treatment unit U2 is configured with a second process manipulator R2, a second lifting buffer box B2 and two columns of processing chambers L3 and L4. The processing chambers L3 and L4 are disposed on both sides of the transmission region 200 oppositely. And each column of treatment chambers has three treatment chambers stacked in the vertical direction. Wherein, the second process manipulator R2 is responsible for transmitting the substrate between the second lifting buffer box B2 and the two columns of processing chambers L3 and L4. The third treatment unit U3 is configured with a third process manipulator R3, a third lifting buffer box B3 and two columns of handling chambers L5 and L6. The handling chambers L5 and L6 are disposed on both sides of the transmission region 200 oppositely. And each column of treatment chambers has three treatment chambers stacked in the vertical direction. Wherein, the third process manipulator R3 is responsible for transmitting the substrate between the third lifting buffer box B3 and the two columns of handling chambers L5 and L6.

In the present embodiment, one first lifting buffer box B1 is configured in the first treatment unit U1, one second lifting buffer box B2 is configured in the second treatment unit U2, and one third lifting buffer box B3 is configured in the third treatment unit U3. Two groups of slots arranged up and down are respectively arranged in the lifting buffer boxes B1 to B3. Wherein, one group of slots positioned below are used for horizontally placing a plurality of substrates to be processed, and the other group of slots positioned above are used for horizontally placing a plurality of processed substrates.

It should be noted that the specific embodiment of the treatment module 20 described above is not used to limit the number of treatment units in the treatment module 20 and the number and layout of treatment chambers configured for each treatment unit. For example, in one embodiment, the treatment module 20 may comprise two, four, or more treatment units arranged in the X direction. In another embodiment, each treatment unit comprises a column of treatment chambers located on one side of the transmission region 200, and each column of treatment chambers has four or more treatment chambers stacked in the vertical direction.

Referring to FIGS. 2 to 4, the transmission region 200 is configured with a transfer manipulator R0 capable of shuttling between the first treatment unit U1 to the third treatment unit U3 in the X direction. The transfer manipulator R0 is also cooperating with the front-end manipulator 121 to transmit the substrate between the carriers 111 and each treatment unit behind the first treatment unit U1. The front-end manipulator 121 transmits the substrate between the carriers 111 and the first lifting buffer box B1. The transfer manipulator R0 moves in the X direction and transmits the substrate between the first lifting buffer box B1 and the second lifting buffer box B2. The second process manipulator R2 transmits the substrate between the second lifting buffer box B2 and a plurality of treatment chambers of the second treatment unit U2, thereby realizing the substrate transmission between the carriers 111 and the second treatment unit U2. Similarly, the transfer manipulator R0 moves in the X direction and transmits the substrate between the first lifting buffer box B1 and the third lifting buffer box B3. The third process manipulator R3 transmits the substrate between the third lifting buffer box B3 and a plurality of treatment chambers of the third treatment unit U3, thereby realizing the substrate transmission between the carriers 111 and the third treatment unit U3.

The transmission region 200 is configured with a transmission frame 210, and a plurality of first vertical guiding rails 211, a plurality of second vertical guiding rails 212 and a transverse guiding rail 213 are disposed in the transmission frame 210. As shown in FIGS. 2 to 4, in the present embodiment, three first vertical guiding rails 211 are configured in the transmission frame 210, for mounting the first process manipulator R1 to the third process manipulator R3 respectively. Three second vertical guiding rails 212 are configured in the transmission frame 210, for mounting the first lifting buffer box B1 to the third lifting buffer box B3 respectively. A transverse guiding rail 213 is configured in the transmission frame 210 for mounting the transfer manipulator R0.

The first process manipulator R1 can be lifted and lowered along the first vertical guiding rail 211, further accessing treatment chambers of any height of the two columns of treatment chambers L1 and L2 and the fixed buffer box B0. The fixed buffer box B0 is a container for temporarily storing the substrate to be processed or processed substrate by means of the first treatment unit U1. The first process manipulator R1 is responsible for transmitting the substrate between the fixed buffer box B0 and a plurality of treatment chambers of the first treatment unit U1. Specifically, the first process manipulator R1 takes up the substrate to be processed from the fixed buffer box B0 and distributes the substrate to a plurality of treatment chambers of the first treatment unit U1, or takes up processed substrate from a plurality of treatment chambers of the first treatment unit U1 and places the substrate in the fixed buffer box B0.

The first lifting buffer box B1 can be lifted and lowered between a low position approaching the transfer manipulator R0 and a high position avoiding the transfer manipulator R0 along the second vertical guiding rail 212. The transfer manipulator R0 is mounted on the transverse guiding rail 213. The transverse guiding rail 213 is arranged in the lower region of the treatment module 20 and extends in the X direction. The transfer manipulator R0 can be translated in the X direction along the transverse guiding rail 213. When the first lifting buffer box B1 rises to a high position, the first lifting buffer box moves away from the moving path of the transfer manipulator R0 and approaches the front-end manipulator 121. The front-end manipulator 121 can transmit the substrate between the carriers 111 and the first lifting buffer box B1. Specifically, the front-end manipulator 121 can take up the substrate to be processed from the carriers 111 and place the substrate in the first lifting buffer box B1, or take up the processed substrate from the first lifting buffer box B1 and place the substrate in the carriers 111. When the first lifting buffer box B1 is lowered to a low position, the first lifting buffer box B1 approaches the transfer manipulator R0, and the transfer manipulator R0 can transmit the substrate between the first lifting buffer box B1 and the second lifting buffer box B2 (or the third lifting buffer box B3). Specifically, the transfer manipulator R0 can take up the substrate to be processed from the first lifting buffer box B1. Then, the transfer manipulator R0 moves to the second lifting buffer box (or the third lifting buffer box B3) along the transverse guiding rail 213 and places the substrate to be processed in the second lifting buffer box (or the third lifting buffer box B3). Alternatively, the transfer manipulator R0 can take up the processed substrate from the second lifting buffer box B2 (or the third lifting buffer box B3). Then, the transfer manipulator R0 moves to the first lifting buffer box B1 along the transverse guiding rail 213 and places the processed substrate in the first lifting buffer box B1.

The second process manipulator R2 can be lifted and lowered along the first vertical guiding rail 211, further accessing treatment chambers of any height of the two columns of processing chambers L3 and L4 and the second lifting buffer box B2. The second lifting buffer box B2 can be lifted and lowered between a low position approaching the transfer manipulator R0 and a high position avoiding the transfer manipulator R0 along the second vertical guiding rail 212. The second lifting buffer box B2 is a container temporarily storing the substrate to be processed or the processed substrate by means of the second treatment unit U2, and the second process manipulator R2 is responsible for transmitting the substrate between the second lifting buffer box B2 and a plurality of treatment chambers of the second treatment unit U2. Specifically, when the second lifting buffer box B2 rises to a high position, the second lifting buffer box B2 approaches the second process manipulator R2, and the second process manipulator R2 takes up the substrate to be processed from the second lifting buffer box B2 and distributes the substrate to a plurality of treatment chambers of the second treatment unit U2, or takes up the processed substrate from a plurality of treatment chambers of the second treatment unit U2 and places the processed substrate in the second lifting buffer box B2. In addition, when the second lifting buffer box B2 is lowered to a low position, the second lifting buffer box B2 approaches the transfer manipulator R0, and the transfer manipulator R0 may have business dealings with the second lifting buffer box B2. Specifically, the transfer manipulator R0 takes out the processed substrate from the second lifting buffer box B2, or places the substrate to be processed in the second lifting buffer box B2.

The third process manipulator R3 can be lifted and lowered along the first vertical guiding rail 211, further accessing treatment chambers of any height of the two columns of handling chambers L5 and L6 and the third lifting buffer box B3. The third lifting buffer box B3 can be lifted and lowered between a low position approaching the transfer manipulator R0 and a high position avoiding the transfer manipulator R0 along the second vertical guiding rail 212. The third lifting buffer box B3 is a container temporarily storing the substrate to be processed or the processed substrate by means of the third treatment unit U3, and the third process manipulator R3 is responsible for transmitting the substrate between the third lifting buffer box B3 and a plurality of treatment chambers of the third treatment unit U3. Specifically, when the third lifting buffer box B3 rises to a high position, the third lifting buffer box B3 approaches the third process manipulator R3, and the third process manipulator R3 takes up the substrate to be processed from the third lifting buffer box B3 and distributes the substrate to a plurality of treatment chambers of the third treatment unit U3, or takes up the processed substrate from a plurality of treatment chambers of the third treatment unit U3 and places the processed substrate in the third lifting buffer box B3. In addition, when the third lifting buffer box B3 is lowered to a low position, the third lifting buffer box B3 approaches the transfer manipulator R0, and the transfer manipulator R0 may have business dealings with the third lifting buffer box B3. Specifically, the transfer manipulator R0 takes out the processed substrate from the third lifting buffer box B3, or places the substrate to be processed in the third lifting buffer box B3.

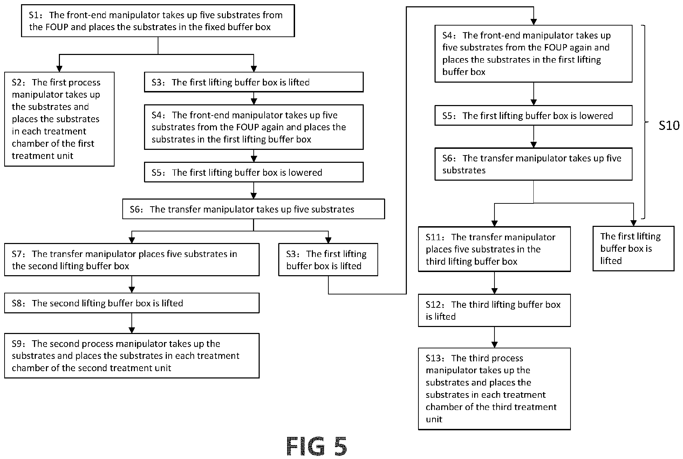

FIG. 5 shows an exemplary flowchart of the transmission of the substrate to be processed from the carriers 111 to the treatment chambers of each treatment unit. The transmission process of the substrate will be described below with reference to FIG. 5. It should be noted in the following description, both the front-end manipulator 121 and the transfer manipulator R0 are multi-arm manipulators capable of simultaneously picking and placing five substrates at a time, and the process manipulators are single-arm manipulators capable of picking and placing one substrate at a time.

S1: The front-end manipulator 121 takes up five substrates (hereinafter referred to as substrates) to be processed from the carriers 111 (FOUP) and places the substrates in the fixed buffer box B0.

S2: The first process manipulator takes up the substrates piece by piece from the fixed buffer box B0 and places the substrates in each treatment chamber of the first treatment unit U1.

S3: The first lifting buffer box is lifted.

S4: The front-end manipulator 121 takes up five substrates from the carriers 111 again and places the substrates in the first lifting buffer box.

S5: The first lifting buffer box is lowered.

S6: The transfer manipulator R0 moves to the first lifting buffer box, and takes up five substrates from the first lifting buffer box.

S7: The transfer manipulator R0 moves to the second lifting buffer box, and places five substrates in the second lifting buffer box.

S8: The second lifting buffer box is lifted.

S9: The second process manipulator takes up the substrates piece by piece from the second lifting buffer box and places the substrates in each treatment chamber of the second treatment unit U2.

S10: Steps S3 to S6 are repeated.

S11: The transfer manipulator R0 moves to the third lifting buffer box, and places five substrates in the third lifting buffer box.

S12: The third lifting buffer box is lifted.

S13: The third process manipulator takes up the substrates piece by piece from the third lifting buffer box and places the substrates in each treatment chamber of the third treatment unit U3.

The above steps S1 to S13 may be repeated until the treatments of all substrates are completed. Wherein, by executing S1 and S2, the substrates can be transmitted from the carriers 111 to a plurality of treatment chambers of the first treatment unit U1. By executing S3 to S9, the substrates can be transmitted from the carriers 111 to a plurality of treatment chambers of the second treatment unit U2. By executing S10 to S13, the substrates can be transmitted from the carriers 111 to a plurality of treatment chambers of the third treatment unit U3. It can be understood that the processed substrates can be returned from the treatment chambers to the carriers 111 according to the original path, and the specific transmission process will not be described in detail.

It should be noted that the above-described numbers S1 to S13 are not used to limit the execution order of each substrate transmission operation. For example, when executing S2: the first process manipulator R1 transmits the piece to each treatment chamber of the first treatment unit U1. Steps S3 to S6 are executed synchronously: the operation of the transfer manipulator R0 acquires the substrates from the first lifting buffer box B1.

It should be noted that the preferred embodiment is that the transfer manipulator R0 transmits the substrates between the first lifting buffer box B1 and the second lifting buffer box B2, or the transfer manipulator R0 transmits the substrates between the first lifting buffer box B1 and the third lifting buffer box B3. It should be understood that the transfer manipulator R0 may transmit the substrates between the first lifting buffer box B1 to the third lifting buffer box B3 in the operation program of the transfer manipulator R0 according to specific process needs. That is, the transfer manipulator R0 can transmit the substrates between the first lifting buffer box B1 and the second lifting buffer box B2 (or the third lifting buffer box), and the transfer manipulator R0 can also transmit the substrates between the second lifting buffer box B2 and the third lifting buffer box B3.

In addition, in order to improve the overall transmission efficiency of the apparatus, a plurality of arms are configured for the front-end manipulator 121 and the transfer manipulator R0 respectively. Specifically, the number of arms configured for the front-end manipulator 121 is 2M, M is a positive integer, and M ≤ P, P is the number of treatment chambers configured for the treatment units. Wherein, M arms are defined as piece-taking arms for taking up the substrate to be processed from the carriers 111, and M arms are defined as piece-placing arms for placing the processed substrate in the carriers 111. For example, the treatment units U1 to U3 are configured with six treatment chambers respectively, and in one embodiment, the number of arms configured for the front-end manipulator 121 is 10. Wherein, 5 arms are piece-taking arms, and the other 5 arms are piece-placing arms. In another embodiment, the number of arms configured for the front-end manipulator 121 is 12, wherein, 6 arms are piece-taking arms and the other 6 arms are piece-placing arms.

In order to improve the flexibility of the front-end manipulator 121 in taking and placing pieces, in the front-end manipulator 121, M piece-taking arms have at least one piece-taking arm for taking up the piece independently, M piece-placing arms have at least one piece-placing arm for placing the piece independently, so as to adapt to different substrate transmission conditions. For example, the carriers 111 which are not in a multiple of 5 grabs the remaining single substrate, grabs the single substrate and the like. As a piece-taking arm for taking up the piece independently, the piece-taking arm can take up one substrate at a time during the process of substrate transmission. Similarity, as a piece-placing arm for placing the piece independently, the piece-placing arm can place one substrate at a time during the process of substrate transmission. For example, the front-end manipulator 121 has six piece-taking arms and six piece-placing arms, among the six piece-taking arms, one of the piece-taking arms can independently take up the piece, that is, one substrate is taken up at a time. And the remaining five piece-taking arms can take up the piece at the same time, that is, five substrates can be taken up at a time. Similarly, among the six piece-placing arms, one of the piece-placing arms can place the piece independently, that is, one substrate is placed at a time. And the remaining five piece-placing arms can place the piece at the same time, that is, five substrates can be placed at one time.

Similar to the front-end manipulator 121, the number of arms configured for the transfer manipulator R0 is 2M, M is a positive integer, and M ≤ P, P is the number of treatment chambers configured for the treatment units. Wherein, M arms are defined as piece-taking arms for taking up the substrate to be processed from the lifting buffer box, and M arms are defined as piece-placing arms for placing the processed substrate in the lifting buffer box.

As a preferred embodiment, the number of piece-taking arms and piece-placing arms configured for the front-end manipulator 121 and the transfer manipulator R0 is the same as the number of treatment chambers configured for a single treatment unit.

In the present application, a horizontally moving transfer manipulator is connected in series with a plurality of vertically moving process manipulators, so as to realize the transmission of substrate from the front end to the back end of the apparatus, or the transmission of substrate from the back end to the front end of the apparatus. The transfer manipulator transmits a plurality of substrates at one time, which can ensure that the substrates to be processed or processed substrates handled by a plurality of process manipulators can be transferred in time. The process manipulators move in the vertical direction and are responsible for the piece transmission tasks of a plurality of treatment chambers. The moving stroke of each process manipulator is shortened and the load is uniform, which is beneficial to reducing the time interval of substrate transmission, improving the transmission efficiency of the substrate, reducing the idle time of the treatment chambers, and further improving the overall production capacity of the apparatus.

### Second embodiment

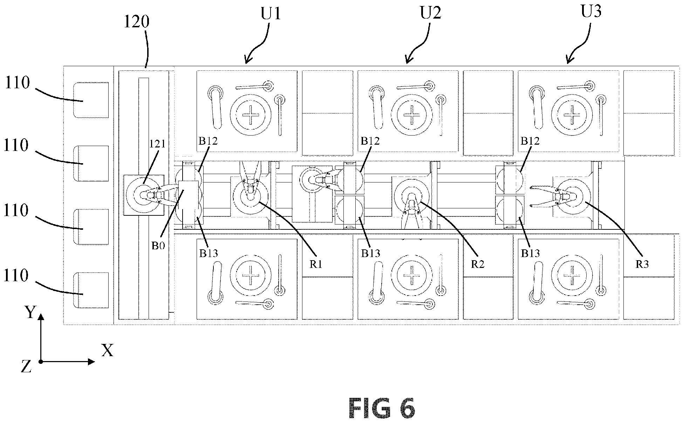

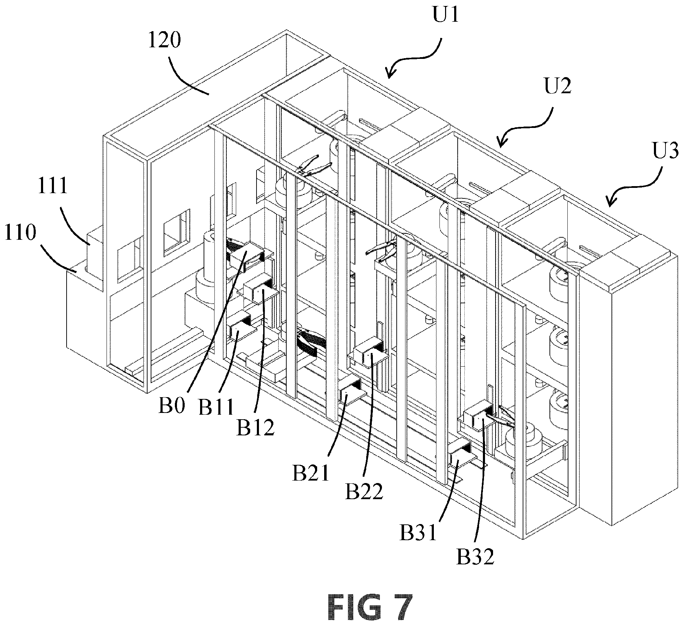

Please referring to FIGS. 6 and 7, the present embodiment provides a substrate treatment apparatus, and compared with the first embodiment, the difference of the present embodiment is that two lifting buffer boxes that move independently are configured for each treatment unit. One of the two lifting buffer boxes is configured for placing the substrate to be processed, and the other of the two lifting buffer boxes is configured for placing the processed substrate.

As shown in FIGS. 6 and 7, the first treatment unit U1 is configured with two first lifting buffer boxes (B11, B12), wherein the first lifting buffer box B11 is configured for placing the substrate to be processed, and the first elevating buffer box B12 is configured for placing the processed substrate. The second treatment unit U2 is configured with two second lifting buffer boxes (B21, B22), the second lifting buffer box B21 is configured for placing the substrate to be processed, and the second elevating buffer box B22 is configured for placing the processed substrate. The third treatment unit U3 is configured with two third lifting buffer boxes (B31, B32), the third lifting buffer box B31 is configured for placing the substrate to be processed, and the third elevating buffer box B32 is configured for placing the processed substrate.

The above embodiments are merely illustrative of the principles and efficacies of the present invention, and are not intended to limit the present invention. Anyone skilled in the art can make modifications or changes to the above-described embodiments without departing from the spirit and scope of the invention. Hence, all equivalent modifications or changes made by those of ordinary skill in the art without departing from the spirit and technical ideas disclosed in the present invention should still be covered by the claims of the present invention.

## Claims

1. A substrate treatment apparatus, comprising a front-end module and a treatment module connected in sequence,
the front-end module being configured with a loading platform and a front-end manipulator, a carrier being provided on the loading platform, the carrier being used for storing the substrate, and the front-end manipulator being used for taking and placing the substrate into the carrier;
the treatment module comprising:
a plurality of treatment units, the plurality of treatment units being the first treatment unit to the Nth treatment unit arranged in sequence from the front end to the back end of the treatment module, an i-th process manipulator, an i-th lifting buffer box, and a plurality of treatment chambers arranged in a stack being configured for the i-th treatment unit, the first treatment unit being arranged adjacent to the front-end module, and the first treatment unit being further configured with a fixed buffer box, wherein, N is a positive integer and N ≥ 2, and i is a positive integer and 1 ≤ i ≤ N; and
a transfer manipulator, configured for moving between the first treatment unit to the Nth treatment unit;
wherein, the front-end manipulator is configured for transmitting the substrate between the carrier and the fixed buffer box; a first process manipulator is used to transmit the substrate between the fixed buffer box and a plurality of treatment chambers of the first treatment unit;
the front-end manipulator is further used to transmit the substrate between the carrier and the first lifting buffer box; the transfer manipulator is used to transmit the substrate between the first lifting buffer box and the j-th lifting buffer box, and the j-th process manipulator is used to transmit the substrate between the j-th lifting buffer box and a plurality of treatment chambers of the j-th treatment unit, j is a positive integer and 2 ≤ j ≤ N.

2. The substrate treatment apparatus according to claim 1, wherein the treatment **module** further comprises a transverse guiding rail, and the transfer manipulator is mounted on the transverse guiding rail, so that the transfer manipulator moves between the first treatment unit to the Nth treatment unit.

3. The substrate treatment apparatus according to claim 1, wherein the treatment module further comprises a first vertical guiding rail, the i-th process manipulator is disposed on the first vertical guiding rail, and the i-th process manipulator is lifted and lowered along the first vertical guiding rail, so as to approach the treatment chamber of any height.

4. The substrate treatment apparatus according to claim 1, wherein the treatment module further comprises a second vertical guiding rail, the i-th lifting buffer box is disposed on the second vertical guiding rail, and the i-th lifting buffer box is lifted and lowered along the second vertical guiding rail, so as to move between the position approaching the transfer manipulator and the position avoiding the transfer manipulator.

5. The substrate treatment apparatus according to claim 1, wherein a plurality of treatment chambers in each treatment unit are stacked in one row in the vertical direction and arranged on one side of the moving path of the transfer manipulator, or stacked in two rows distributed on both sides of the moving path of the transfer manipulator and provided opposite to each other.

6. The substrate treatment apparatus according to claim 1, wherein M piece-taking arms and M piece-placing arms are configured for the front-end manipulator and the transfer manipulator respectively, wherein M and P are positive integers, and M ≤ P, P is the number of treatment chambers configured for each treatment unit.

7. The substrate treatment apparatus according to claim 6, wherein in the front-end manipulator, M piece-taking arms have at least one piece-taking arm that takes up the piece independently, M piece-placing arms have at least one piece-placing arm that places the piece independently.

8. The substrate treatment apparatus according to claim 1, wherein each treatment unit is configured with two lifting buffer boxes moving independently, wherein, one of the two lifting buffer boxes is configured for placing the substrate to be processed, and the other of the two lifting buffer boxes is configured for placing the processed substrate.
